Europäisches Patentamt

European Patent Office

Office européen des brevets

(19)

(11) Publication number: **0 013 562**
**B1**

# (12) EUROPEAN PATENT SPECIFICATION

(45) Date of publication of patent specification: **04.08.82**

(21) Application number: **80100042.3**

(22) Date of filing: **04.01.80**

(51) Int. Cl.³: **H 01 L 23/14, H 01 L 21/48**
**//H01L21/60**

(54) **Method of making electronic packages.**

(30) Priority: **10.01.79 US 2473**

(43) Date of publication of application:
**23.07.80 Bulletin 80/15**

(45) Publication of the grant of the patent:
**04.08.82 Bulletin 82/31**

(84) Designated Contracting States:
**DE FR GB**

(56) References cited:
**FR - A - 2 317 853**
**US - A - 3 781 596**
**US - A - 3 868 724**

**ELECTRONICS, vol. 46, March 29, 1973**
**New York US**
**M. A. BERGER et al. "Flat flexible cable makes**
**excellent IC interface pages 86—91**

(73) Proprietor: **International Business Machines**
**Corporation**
**Armonk, N.Y. 10504 (US)**

(72) Inventor: **Gazdik, Charles Edward**
**911 Westminster Rd.**
**Endicott, N.Y. 13760 (US)**
Inventor: **McBride, Donald Gene**
**2058 Cheshire Rd.**
**Binghamton, N.Y. 13903 (US)**

(74) Representative: **Barth, Carl Otto, Dipl.-Ing.**
**Rablstrasse 24**
**D-8000 München 80 (DE)**

(56) References cited:
**IBM TECHNICAL DISCLOSURE BULLETIN vol.**
**12, March 1970**
**New York, US**
**A. H. JOHNSON et al. "Chip heat sink package**
**assembly", page 1665**

(continued overleaf)

Courier Press, Leamington Spa, England.

(56) References cited:
IBM TECHNICAL DISCLOSURE BULLETIN, 1 vol.
20, December 1977,
New York US
R. A. FOSTER et al. "Thermally enhanced
package for semiconductor devices", pages
2637—2638

IBM TECHNICAL DISCLOSURE BULLETIN vol. 20,
May 1978
New York US
J. AHN et al "Permalloy solder barrier for devices
with gold conductor metallization", page 5317

IBM TECHNICAL DISCLOSURE BULLETIN vol. 21,
December 1978,
New York, US
M. ECKER: "Multilever alloy joining system for
semiconductor dies", pages 2743—2746

Method of making electronic packages

This invention relates to a method of making electronic packages which require a thin and flexible printed circuit polymer substrate according to the first part of claim 1. The method according to the first part of claim 1 is known from US—A—3 781 596.

US—A—3,780,352 shows an electronic package assembly in which a sheet of insulating material, which supports metallic film strips, is positioned between a semiconductor device mounted thereon and a pin carrier of ceramic. The metallic film strips are bonded to the heads of the carrier pins and the contact pads of the semiconductor device.

In the prior art, the formation of thin flexible polymer, particularly polyimide printed circuit (PC) tapes, have been generally heretofore limited to thicknesses of approximately 13 $\mu$m to 76 $\mu$m, cf. US—A—3,781,596, for example.

Because of the thermal mismatch between pin carrier, PC member and semiconductor device, the bonds between the PC member and the pads of the semiconductor device and the heads of the pins are subject to stresses which cause failure of the bond joint and, hence, failure of the packaged device. These stresses may be caused, for example, by thermal cycling such as that encountered under a test environment or under actual environmental conditions during the operation of the package when installed.

The PC member itself could act as a strain relief to relieve the aforesaid stresses. However, the thicknesses of the prior art PC members did not provide the degree of flexibility required to accomplish the desired result. Moreover, the temperatures and pressures associated with the making of the PC member and the bonding at the semiconductor device pads or at the pin sites would stiffen the polymer, in particular polyimide, material in the vicinity of the sites. Thus, the flexibility of the polymer material at the bonding sites was destroyed or lost so that it could not provide a satisfactory strain relief. With the advent of high density (i.e. 100 or more) input/output (I/O) terminal semiconductor devices or chips, the problem became even more acute. The problem is further compounded when the chip is rigidly affixed to another structural member, for example, when the chip is backbonded to the cover of the assembly or an intervening thermal conductive member for enhancing the dissipation of heat associated with the chip or assembly.

The invention as claimed in claim 1 provides a solution for these problems. It provides a highly reliable, thin and flexible interconnection, which minimizes the risk of damaging the polymer substrate's flexibility and/or integrity particularly in proximity to the bonding sites at the terminal to pad interconnections, as well as the pin to land interconnections. It is particularly useful for making electronic package assemblies which are subject to thermal cycle stresses, where the chip is to be rigidly affixed to another structure, or where the chip and the used carrier base have different thermal characteristics, such as a silicon chip and a ceramic base. The floating-like action of the interconnection between the chip and the carrier base provides enhanced relief for stresses caused by thermal cycling.

Ways of carrying out the invention will be apparent from the following detailed description with reference to the drawings, in which:

Fig. 1 is a schematic cross-sectional view, partially broken away, illustrating an electronic package assembly made according to this invention;

Fig. 2 is an enlarged partial cross-sectional view, taken along the lines 2—2 of Fig. 3, illustrating certain details of the assembly of Fig. 1;

Fig. 3 is a partial planar view of a detail of the assembly of Fig. 1;

Fig. 4A—4I are perspective, partly cross-sectional views illustrating certain stages of a method of carrying out the invention;

Fig. 5 is a perspective view illustrating a stage of the method and

Fig. 6A—6D are cross-sectional views illustrating some stages of a method for manufacturing an electronic package according to the invention.

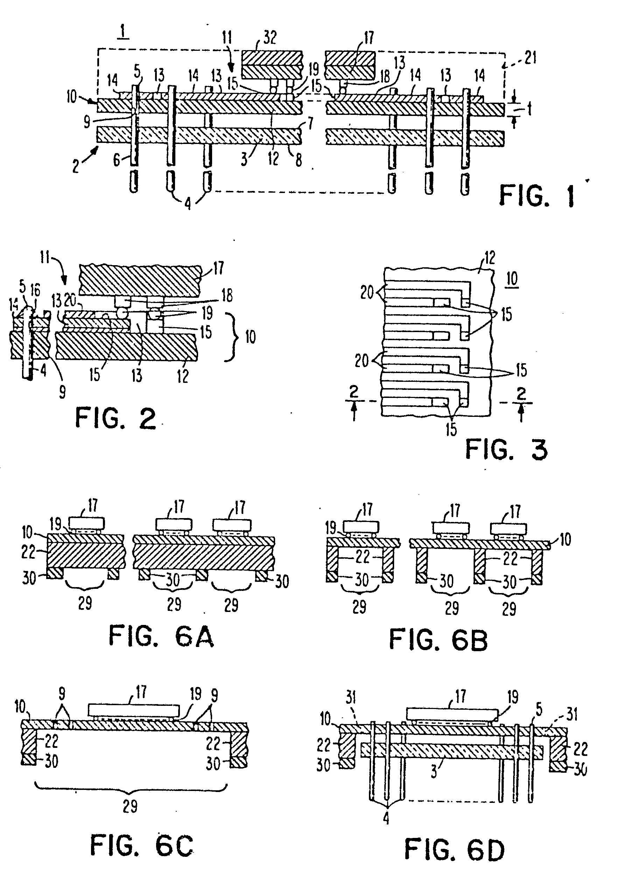

Fig. 1 shows in schematic form a cross-sectional view of the type of electronic package assembly, generally indicated by reference number 1, made according to this invention. Assembly 1 contains a pin carrier member 2 with a planar rectangular insulator, e.e. ceramic base 3, and plural conductive pins 4. Pins 4 are embedded in base 3 around its periphery and are arranged in two concentric rectangular arrays so as to form two parallel rows of aligned pins 4 on each edge of base 3. Each of the embedded pins 4 extends through base 3 to provide respective first and second extensions generally indicated by respective reference numbers 5 and 6 above the top and bottom surfaces 7 and 8, respectively, of base 3. The shorter extensions are hereinafter referred to as heads 5. The longer extensions 6 are the parts that are adapted to be plugged into some compatible mating connectors or receptacles, not shown.

Heads 5 are passed through apertures or openings 9 of a thin flexible printed circuit member 10. Member 10 has a printed circuit conductor pattern, generally indicated by reference number 11, on its polymer, (preferably polyimide) film or substrate 12. Substrate 12 has a thickness t of substantially five $\mu$m.

Printed circuit pattern 11 consists of a plurality of conducting elements, e.g. conductors 13, apertured lands 14 and pads 15, cf. Fig. 2. Predetermined ones of conductors 13 are terminated in lands 14, each of which is concentric with one of the apertures 9 and is bonded to head 5 of the particular pin 4 passed therethrough by suitable bonding means, e.g. solder 16. In a similar manner, preselected ones of conductors 13 are terminated in pads 15. It should be understood that in most applications two ends of most of the conductors 13 are terminated with a land 14 and pad 15, respectively. However, certain conductors 13 can be terminated on two of their ends with lands 14 to effect intraconnections of certain pins 4, if desired.

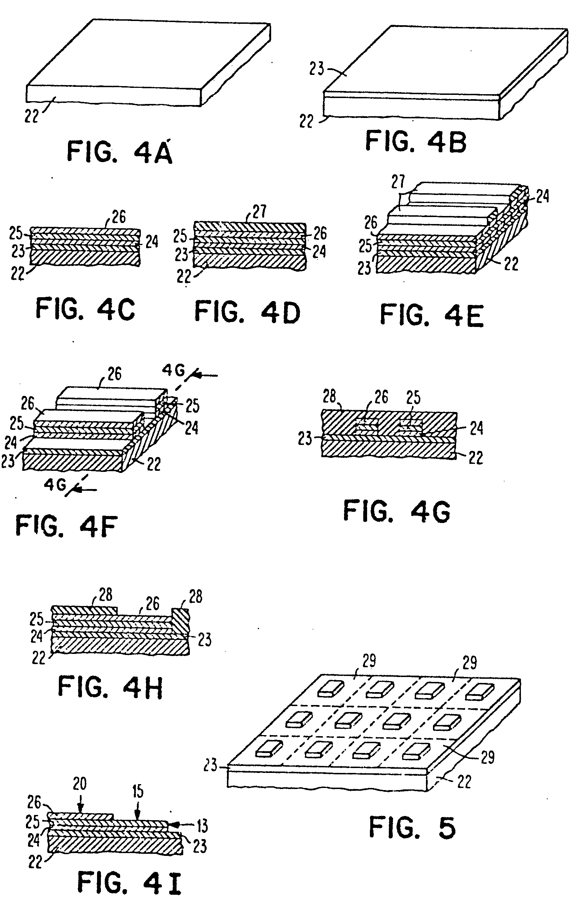

Mounted on member 10 is at least one integrated circuit semiconductor device or chip 17 which has on its active surface a plurality of input/output terminals 18, as shown in greater detail in Fig. 2. Terminals 18 are arranged in a predetermined array, e.g. a high density array with 100 or more terminals. Pads 15 on base 3 are arranged in a compatible array, cf. Fig. 3, which is in aligned register with the terminal array of chip 17. It should be understood that some of the conductors 13 can be terminated on two of its ends with pads 15 to connect terminals 18 of the same chip 17, or to interconnect respective terminals 18 of two chips 17 in those cases where more than one chip 17 is mounted on member 10. A controlled collapse chip connection process, referred to in the art as C—4, may be used to bond terminals 18 to their associated pads 15 via reflow solder connectors 19 which are prefixed to terminals 18. Preferably, pads 15 as well as lands 14 have been presoldered to facilitate bonding of terminals 18 and pin heads 5, respectively, thereto. A suitable solder stop 20 can be located on each respective conductor 13, covering it except for the bonding sites of lands 14 and pads 15 and thus preventing solder 16 and solder connector 19 from moving away from the particular land 14 or pad 15. The respective arrays of terminals 18 and pads 15 of chip 17 and member 10, respectively, are only partially shown in the figures. Assembly 1 is hermetically sealed within a suitable module container or cover 21 shown schematically in dash outline form in Fig. 1. Extensions 6 of pins 4 protrude from container 21 so as to be engageable into mating receptacles, not shown. A method for making this electronic package assembly 1 will next be described with reference to Figs. 4A—6D.

A temporary planar support 22, Fig. 4A, is provided. For batch processing, support 22 is in the form of a panel. Support 22 is made of a removable material, preferably an etchable material such as aluminum, invar (an iron-nickel alloy), Kovar® (Registered Trademark of Westinghouse Electric Corp. for an ironnickel-cobalt alloy) or the like. Support 22 is precleaned and polished. An integral layer 23 of uncured liquid polyimide is formed on a surface of support 22, cf. Fig. 4B. Layer 23 is cast on support 22, preferably by spraying, to a thickness which is compatible to achieve the desired tickness t of substantially five $\mu$m when the polyimide layer 23 is subsequently cured. A polyimide suitable for layer 23 is manufactured by DuPont de Nemours and Co., under the product name of DuPont Polyimide 5057.

Prior to curing, the polyimide liquid layer 23 is dried. In the described embodiment, the drying takes place at a temperature of approximately 125°C for about 15 minutes. Subsequently, layer 23 is cured. This occurs at temperature of approximately 350°C for about 5 minutes.

The next phase of the process involves the formation of printed circuit patterns 11 on polyimide layer 23 at the different package assembly sites thereof. To this end, successive integral layers 24, 25, 26 of chromium, copper, and chromium, respectively, are applied by conventional evaporation processes on the planar surface of the cured polyimide layer 23, Fig. 4C. Chromium layer 24 provides improved adherence for copper layer 25 than would be the case if layer 25 were to be directly evaporated to the polyimide layer 23. Chromium layer 26 forms the solder stops 20 as hereinafter explained. Next, an integral layer 27 of a suitable photoresist, e.g. the photoresist manufactured by Eastman Kodak Co. under the product name of KTFR, is applied to the outer surface of layer 26 and then exposed through a mask, not shown, containing the desired PC pattern image, cf. Fig. 4D. Photo-resist layer 27 is then developed in a suitable developer. Thus, for the given KTFR photoresist example, a KTFR developer is used. As a result, the remaining photoresist of layer 27 is left as an etchant mask with the configuration of the desired PC patterns 11 of conductors 13, cf. Fig. 4E.

Thereafter, the excess chromium and copper of layer 24—26 not covered by the photoresist mask formed by layer 27 are successively etched by suitable etchants. More specifically, in the given embodiment, chromium layer 26 is first etched with an etchant mixture of potassium permanganate/potassium hydroxide. Next, copper layer 25 is etched with an etchant of ferric chloride, followed by the etching of chromium layer 24 with an etchant of the same type used to etch layer 26. Layers 24—27 now contain the desired PC conductor patterns 11. The photoresist mask formed from layer 27 is then removed, i.e. stripped, with a conventional stripper and the layers 24—26 rinsed in an appropriate rinse, as is well-known to those skilled in the art.

A second photoresist layer 28 of the same type used for layer 27 is next applied to the exposed surfaces of the upper layers 23—26, cf. Fig. 4G. Layer 28 is used to form an etchant mask associated with making the solder stops 20. Layer 28 is exposed through another suitable mask, not shown, which contains the desired chromium solder stop pattern associated with lands 14 and pads 15. Layer 28 is then developed in a suitable developer of the same type used to develop layer 27. As a result, layer 28 is removed from atop the regions of chromium layer 26 that are co-extensive with the regions of copper layer 25 that form the lands 14 and pads 15, cf. Fig. 4H. The chromium of layer 26 which covers lands 14 and pads 15 of layer 25 is then etched in an etchant of the type such as, for example, the aforementioned mixture of potassium permanganate/potassium hydroxide. As a result, the remaining chromium of layer 26 forms the stops 20 which act as a solder barrier stop for the rest of printed circuit pattern 11 covered thereby. Thereafter the photoresist mask formed from layer 28 is removed, cf. Fig. 41, in a manner similar to that used to remove the photoresist mask of layer 27. Polyimide layer 23 is now circuitized with printed circuit pattern 11.

Alternatively, chromium layer 26 is removed from the top of lands 14 and pads 15 prior to the formation of the circuit lines. This allows the two associated photoresist layers to be applied to a more uniform surface.

In the next phase of the process, chips 17, which have solder connectors 19 preaffixed to their I/O terminals 18 as aforementioned, are mounted to the circuitized polyimide layer 23 at each of the package assembly sites generally indicated by the reference numbers 29, cf. Fig. 5. Lands 14 and pads 15 have been pretinned by a conventional solder wave process. A C—4 process is used to bond solder connectors 19 and, hence terminals 18 to their respective associated pads 15. For sake of explanation and clarity, in Fig. 5 only one chip 17 is shown mounted in each of the sites 29, it being understood that plural chips 17 can be mounted at one site as is obvious to those skilled in the art. In Fig. 5 and 6A—6D, printed circuit patterns 11 and terminals 18 are not shown.

The next phase of the process involves affixing the heads 5 of pins 4 to polyimide layer 23. An etch resistant mask 30, cf. Fig. 6A, is applied to the outer surface of support 22. For the given materials example of support 22, mask 30 is a hydrocarbon wax, such as the type sold by Shell Oil Company under the trademark Apiezon®, that is applied through a screen or stencil, not shown. As a result, a wax etchant mask 30 is formed on the outer surface of support 22 with cutouts or windows slightly larger than and beneath each assembly site 29, each of which includes a pattern 11. Support 22 is then etched through mask 30 using a suitable etchant. For example, hydrochloric acid can be used as an etchant for aluminum, and ferric chloride can be used for invar or Kovar®. The etching is stopped when access to polyimide layer 23 is reached, as shown in Fig. 6B.

Holes 9 are then pierced by a heated piercing tool, not shown, into polyimide layer 23 at each site 29 through the apertured lands 14 of member 10, which are arranged in the aforementioned two concentric rectangular arrays, cf. Fig. 6C. Next, heads 5 of pins 4 are inserted through holes 9 and pins 4 are solder bonded to their respective concentric lands 14, cf. Fig. 6D. Next, the individual assemblies are cut out of or away from the support 22 by cutting polyimide layer 23 along appropriate predetermined cutting lines, cf. for example, lines 31 in Fig. 6D. Each assembly is then sealed in container 21, cf. Fig. 1. Preferably, container 21 is of a suitable thermally conductive material, such as aluminum, and chip 17 is then thermally backbonded to it by, for example, solder bond 32. To this end, the back of chip 17 may be presoldered and solder reflow bonded to effect bond 32. In certain cases, the sealing of cover 21 and/or backbonding of chip 17 thereto can be effected while polyimide layer 23 is still being supported by the remainder, i.e. unetched portions, of support 22.

It should be understood, that, in the figures, the thickness dimensions of member 10 and terminals 18 have been greatly exaggerated and enlarged with respect to the corresponding dimensions of base 3, chip 17 and support 22. Also in Figs. 5, 6A—6D the printed circuit patterns 11 have been omitted.

In the aforedescribed embodiment, three levels 24, 25, 26 of metallization, chromium, copper, chromium are preferably employed. Generally, chromium levels 24 and 26 have thickness dimensions in the order of 70 nm each and copper layer 25 has a thickness dimension in the preferred range of 4 to 8 $\mu$m. In the figures, the corresponding thickness dimensions have been exaggerated. It should be understood, however, that other thickness dimensions or other materials or other numbers of levels can be used for levels 24—26, as is obvious to those skilled in the art. Thus for example, in certain applications only a single level of conductive material for forming the PC conductors can be used, with or without the use of solder stops.

Moreover, the polyimide or any other polymer layer can be first formed on the permanent conductive layer of a multilayer strippable member such as peel-apart copper or etch-apart copper. The outer surface of the polyimide layer so formed is then affixed to a temporary carrier such as support 22 by, for example, a removable epoxy. The strippable layer of the multilayer member is then removed leaving the remaining permanent conductive layer for forming circuitry therewith into the desired printed circuit pattern. In such a case, the strippable layer and temporary support coact as a temporary support means.

## Claims

1. A method for packaging an electronic circuit chip (17) having a plurality of terminals (18) to be selectively connected via conductors (13) on a flexible insulating polymer film (12) to pins (4) arranged in an insulating carrier base (3) characterized by providing a support means (22), forming a layer (23) of curable liquid polymer, preferably polyimide, on said support means (22), or on a conductor layer, curing said polymer, circuitizing said cured polymer film (12) being affixed to said support means (22) with a predetermined pattern (11) of conductors (13, 14, 15), selectively bonding said terminals (18) to said conductors (13,14,15), removing at least part of said support means (23), and selectively bonding said conductors (13,14,15) to said pins (4).

2. The method of claim 1, wherein said layer of cured polymer film (12) has a thickness of use to substantially 5 µm.

3. The method of claim 1, wherein said support means (22) comprises etchable material and said removing step includes etching away at least portions of said etchable material through an etch resistance mask (30).

4. The method of claim 1, wherein the bonding of said terminals (18) to said conductors (13,14,15) comprises a controlled collapse chip connection process.

5. The method of claim 1, further comprising a step of removing any remainder of said support means (22) after bonding said conductors (13,14,15) to said pins (4).

6. The method of claim 1, further including a step of selectively cutting said polymer film (12) around said predetermined pattern of conductors (13,14,15).

7. The method of claim 1, wherein the circuitizing step comprises evaporating successive layers of chromium, copper, and chromium (24,25,26) on said polymer film (12,23), forming said predetermined pattern of conductors (13,14,15), and removing portions of said last chromium layer (26) to provide bonding sites (14,15) on said copper layer (25).

8. The method of claim 7, further comprising a step of providing a hole (9) in said polymer film (12) and through at least one of said bonding sites (14,15) for bonding said conductors (13) to said pins (4).

9. The method of claim 1, further including including a step of providing a thermal backbond (32) for said chip (17) to a thermally conductive member (21).

10. The method of claim 1, wherein the forming step includes spraying an integral layer of said liquid polymer (23) on one surface of said support means (22).

11. The method of claim 1, further including a step of drying said layer of liquid polymer (23) before it is cured.

12. The method of claim 11 wherein the step of drying takes place at a temperature of approximately 125°C for approximately 15 minutes and the step of curing occurs at approximately 350°C for approximately 5 minutes.

## Patentansprüche

1. Verfahren zum Zusammenbau eines elektronischen Schaltkreischips (17), der eine Mehrzahl von Anschlüssen (18) hat, die selektiv über Leitungen (13) auf einer flexiblen, isolierende Polymerfolie (12) mit in einem isolierende Basisteil (3) angeordneten Stiften (4) verbunden werden, gekennzeichnet durch, das Vorsehen von Trägermitteln (22), Ausbildung einer Schicht (23) eines härtbaren Flüssigpolymers, vorzugsweise Polyimid, auf diesem Trägermittel (22) oder einer Leiterlage, Wärmehärten des Polymers, Ausbildung von Schaltkreisen in der auf dem Trägermittel (22) angeordneten gehärteten Polymerfolie (12) mit einem bestimmten Muster (11) von Leitungen (13, 14, 15), selektiver Verbindung der Anschlüsse (18) mit den Leitungen (13, 14, 15), Entfernung zumindest eines Teils des Trägermittels (22) und selektiver Verbindung der Leitungen (13, 14, 15) mit den Stiften (4).

2. Verfahren nach Anspruch 1, worin die gehärtete Polymerfolie (12) eine Dicke von bis zu ungefähr 5 µm aufweist.

3. Verfahren nach Anspruch 1, worin das Trägermittel (22) ätzbares Material enthält, und der Verfahrensschritt der Entfernung das Wegätzen von zumindest Teilen dieses ätzbaren Materials mittels einer ätzbeständigen Maske (30) einschließt.

4. Verfahren nach Anspruch 1, worin die Verbindung der Anschlüsse (18) mit den Leitungen (13, 14, 15) ein Verbindungsverfahren des kontrolliertes Aufschmelzen von Lötperlen einschließt.

5. Verfahren nach Anspruch 1, weiterin gekennzeichnet durch einen Verfahrensschritt der Entfernung aller Reste des Trägermittels (22) nachdem die Leitungen (13, 14, 15) mit den Stiften (4) verbunden sind.

6. Verfahren nach Anspruch 1, weiterhin gekennzeichnet durch einen Verfahrensschritt des selektiven Schneidens der Polymerfolie (12) um das vorbestimmte Leitungsmuster (13, 14, 15) herum.

7. Verfahren nach Anspruch 1, worin der Verfahrensschritt Schaltkreisausbildung einschließt: das Aufdampfen aufeinanderfolgender Lagen von Chrom, Kupfer und Chrom (24, 25, 26) auf die Polymerfolie (12, 23), die Bildung der vorbestimmten Leitungsmuster (13, 14, 15) und die Entfernung von Teilen der Letzten Chromschicht (26) um Anschlußstellen (14, 15) auf der Kupferschicht (25) vorzusehen.

8. Verfahren nach Anspruch 7, weiterhin gekennzeichnet durch einen Verfahrensschritt, bei dem eine Öffnung (9) in der Polymerfolie (12) und durch zumindest eine der Anschlußstellen (14, 15) vorgesehen ist, um die Leiter (13) mit den Stiften (4) zu verbinden.

9. Verfahren nach Anspruch 1, weiterhin gekennzeichnet durch einen Verfahrensschritt, der eine thermische Verbindung (32) für das Chip (17) zu einem thermisch leitfähigen Bauteil (21) vorsieht.

10. Verfahren nach Anspruch 1, worin der Verfahrensschritt der Schichtbildung das Aufsprühen einer ununterbrochenen Schicht des flüssigen Polymers (23) auf eine Oberfläche des Trägermittels (22) einschließt.

11. Verfahren nach Anspruch 1, weiterhin gekennzeichnet durch einen Verfahrensschritt des Trocknens der flüssigen Polymerschicht (23), bevor diese gehärtet wird.

12. Verfahren nach Anspruch 11, worin der Verfahrensschritt der Trocknung bei einer Temperatur von ungefähr 125°C für ca. 15 Minuten und der Verfahrenschritt der Härtung bei ungefähr 350°C für ca. 5 Minuten stattfinden.

## Revendications

1. Procédé d'assemblage d'une microplaquette de circuits électroniques (17) comportant plusieurs bornes (18) á connecter sélectivement par l'intermédiaire des conducteurs (13) portés par un film de polymére isolant flexible (12), aux broches (4) disposées dans un support isolant (3), caractèrisè en ce qu'il comprend les étapes suivantes: la réalisation d'un moyen de support (22), la formation d'une couche (23) de polymère liquide pouvant être cuit, de préférence du polyimide, sur ledit moyen de support (22) ou sur une couche conductrice, la cuisson dudit polymère, la formation de circuits sur ledit film de polymère cuit (12) fixé audit moyen de support (22) selon une configuration prédéterminée (11) de conducteurs (13, 14, 15), la liaison sélective desdites bornes (18) et desdits conducteurs (13, 14 15), le retrait d'au moins une partie dudit moyen de support (22), et la liaison sélective desdits conducteurs (13, 14, 15) et desdites broches (4).

2. Procédé selon la revendication 1, caractérisé en ce que ladite couche du film de polymère cuit (12) présente une épaisseur pouvant pratiquement atteindre 5 $\mu$m.

3. Procédé selon la revendication 1, caractérisé en ce que ledit moyen de support (22) comprend du matériau pouvant être décapé et en ce que ladite étape de retrait comprend le retrait per décapage d'au moins certaines parties dudit matériau pouvant être décapé au travers d'un masque de résistance au décapage (30).

4. Procédé selon la revendication 1, caractérisé en ce que l'étape de liaison desdites bornes (18) auxdits connecteurs (13, 14, 15) comprend l'exécution d'un procédé de connexion de microplaquettes par assemblage commandé.

5. Procédé selon la revendication 1, caractérisé en ce qu'il comprend en outre une étape de retrait de tout le reste dudit moyen de support (22) après la réalisation de la liaison des conducteurs (13, 14, 15) et des broches (4).

6. Procédé selon la revendication 1, caractérisé en ce qu'il comprend en outre une étape de découpage sélectif dudit film de polymère (12) autour de ladite configuration prédéterminée de conducteurs (13, 14, 15).

7. Procédé selon la revendication 1, caractérisé en ce que l'etape de formation des circuits comprend les opérations suivantes: l'évaporation de couches successives de chrome, de cuivre et de chrome (24, 25, 26) sur le film de polymère (12, 23), la formation de ladite configuration prédéterminée de conducteurs (13, 14, 15), et le retrait de parties de la dernière couche de chrome (26) pour réaliser des points de liaison (14, 15) sur ladite couche de cuivre (25).

8. Procédé selon la revendication 7, caractérisé en ce qu'il comprend en outre une étape de réalisation d'un trou (9) dans le film de polymère (12) traversant au moins l'un desdits points de liaison (14, 15) pour la liaison desdits conducteurs (13) auxdites broches (4).

9. Procédé selon la revendication 1, caractérisé en ce qu'il comprend en outre la réalisation d'un support (32) pour lier thermiquement la microplaquette (17) à un élément thermiquement conducteur (21).

10. Procédé selon la revendication 1, caractérisé en ce que l'étape de formation comprend la pulvérisation d'une couche intégrale dudit polymère liquide (23) sur une surface dudit moyen de support (22).

11. Procédé selon la revendication 1, caractérisé en ce qu'il comprend une étape de séchage de ladite couche de polymère liquide (23) avant sa cuisson.

12. Procédé selon la revendication 11 caractérisé en ce que l'étape de séchage est effectuée à une température d'approximativement 125°C pendant approximativement 15 minutes et en ce que l'étape de cuisson se déroule à approximativement 350°C pendant approximativement 5 minutes.

FIG. 1

FIG. 2

FIG. 3

FIG. 6A

FIG. 6B

FIG. 6C

FIG. 6D

FIG. 4A

FIG. 4B

FIG. 4C

FIG. 4D

FIG. 4E

FIG. 4F

FIG. 4G

FIG. 4H

FIG. 4I

FIG. 5